# EUROPEAN PATENT APPLICATION

(11) **EP 4 258 838 A1**
(43) Date of publication of application: **11.10.2023**
(21) Application number: 20964246.1
(22) Date of filing: 02.12.2020
(51) Int. Cl.: H05K 13/02

(54) **COMPONENT CONFIRMATION DEVICE AND COMPONENT CONFIRMATION METHOD**

(71) Applicant: Fuji Corporation, Chiryu-shi, Aichi 472-8686 (JP)
(72) Inventor: SUGIHARA, Kohei, Chiryu-shi, Aichi 472-8686 (JP); KUBOTA,Tomokatsu, Chiryu-shi, Aichi 472-8686 (JP)
(74) Representative: Grünecker Patent- und Rechtsanwälte PartG mbB
(86) International application number: PCT/JP2020/044838
(87) International publication number: WO 2022/118392

(57) **Abstract**

A component confirmation device images components arranged in a pallet before the components are picked up to confirm the components based on a captured image of the components. A pick-and-place cycle is defined as a cycle from when a mounting head configured to pick up and mount a component on a board starts picking up a target component that is at least one of the components that the mounting head picks up at one time until when the mounting head mounts the target component on the board. At this time, the component confirmation device includes a moving section configured to move target equipment that is a first one of a lighting device configured to illuminate the target component and the pallet, relative to a second one of the lighting device and the pallet as required every pick-and-place cycle, in imaging of the target component.

## Description

### Technical Field

The present description discloses a technique relating to a component confirmation device and a component confirmation method.

### Background Art

The electronic component supply device described in Patent Literature 1 allows to designate a position on an operation panel which is associated with the position of a pocket in a tray which accommodates an electronic component to thereby input the position of the pocket in the tray which accommodates the electronic component. With this configuration, in a case in which a tray accommodating electronic components only in some of pockets thereof is used in the electronic component supply device, with the electronic component supply device, a pocket which accommodates an electronic component can be designated.

### Patent Literature

Patent Literature 1: JP-A-2005-159177

### Summary of the Invention

### Technical Problem

Some of component supply devices image components arranged in a pallet before picking up the components, so as to confirm the components based on a captured image of the components. In this case, the component supply device includes a lighting device that illuminates the components in imaging of the components. However, the lighting device tends to have a limited lighting area, as a result of which all the components arranged in the pallet cannot be illuminated at one time in some cases.

In a case in which the components are confirmed using the lighting device described above, a first one of the pallet and the lighting device needs to be moved relative to a second one of them. For example, if the pallet is moved in order to pick up a subsequent component every time one of the components accommodated in the pallet is picked up, a waiting time is required until the movement of the pallet is completed. As a result, there is a possibility that the number of components mounted per unit time is reduced, resulting in a possibility that the production efficiency is reduced.

In view of these circumstances, the present description discloses a component confirmation device and a component confirmation method which can prevent a reduction in production efficiency by moving a first one of a pallet and a lighting device relative to a second one thereof at a predetermined timing when imaging components arranged in the pallet.

### Solution to Problem

The present description discloses a component confirmation device for imaging components arranged in a pallet before the components are picked up to confirm the components based on a captured image of the components. A pick-and-place cycle is defined as a cycle from when a mounting head configured to pick up and mount a component on a board starts picking up a target component that is at least one component that the mounting head picks up at one time until when the mounting head mounts the target component on the board. At this time, the component confirmation device includes a moving section configured to move target equipment that is a first one of a lighting device configured to illuminate the target component and the pallet, relative to a second one of the lighting device and the pallet as required every pick-and-place cycle, in imaging of the target component.

The present description also discloses a component confirmation method for imaging components arranged in a pallet before the components are picked up to confirm the components based on a captured image of the components. A pick-and-place cycle is defined as a cycle from when a mounting head configured to pick up and mount a component on a board starts picking up a target component that is at least one component that the mounting head picks up at one time until when the mounting head mounts the target component on the board. At this time, the component confirmation method includes a moving step of moving target equipment that is a first one of a lighting device configured to illuminate the target component and the pallet, relative to a second one of the lighting device and the pallet as required every pick-and-place cycle, in imaging of the target component.

### Advantageous Effect of the Invention

According to the component confirmation device described above, the component confirmation device includes the moving section. As a result, when the target component is imaged, the component confirmation device can move the target device, which is the first one of the lighting device and the pallet, relative to the second one of the lighting device and the pallet as required every pick-and-place cycle. Consequently, the component confirmation device can prevent a reduction in production efficiency compared with a case in which the pallet or the lighting device is moved in order to pick up a subsequent component every time a component is picked up. What has been described on the component confirmation device can similarly be said for the component confirmation method.

### Brief Description of Drawings

Fig. 1 is a plan view illustrating a configuration example of a component mounter.
Fig. 2 is a block diagram illustrating an example of control blocks of a component confirmation device.
Fig. 3 is a flowchart illustrating an example of a control procedure executed by the component confirmation device.
Fig. 4 is a plan view illustrating an example of positioning of a pallet (target equipment).
Fig. 5 is a plan view illustrating another example of positioning of the pallet (the target equipment).
Fig. 6 is a plan view illustrating a further another example of positioning of the pallet (the target equipment).
Fig. 7 is a plan view illustrating an arrangement example of components arranged in the pallet.
Fig. 8 is a plan view of the pallet illustrating an example of setting of a pick-and-place cycle.
Fig. 9 is a side view of a target component illustrating an example of a lighting direction of a lighting device.

### Description of Embodiments

### 1. Embodiment

### 1-1. Configuration Example of Component Mounter 10

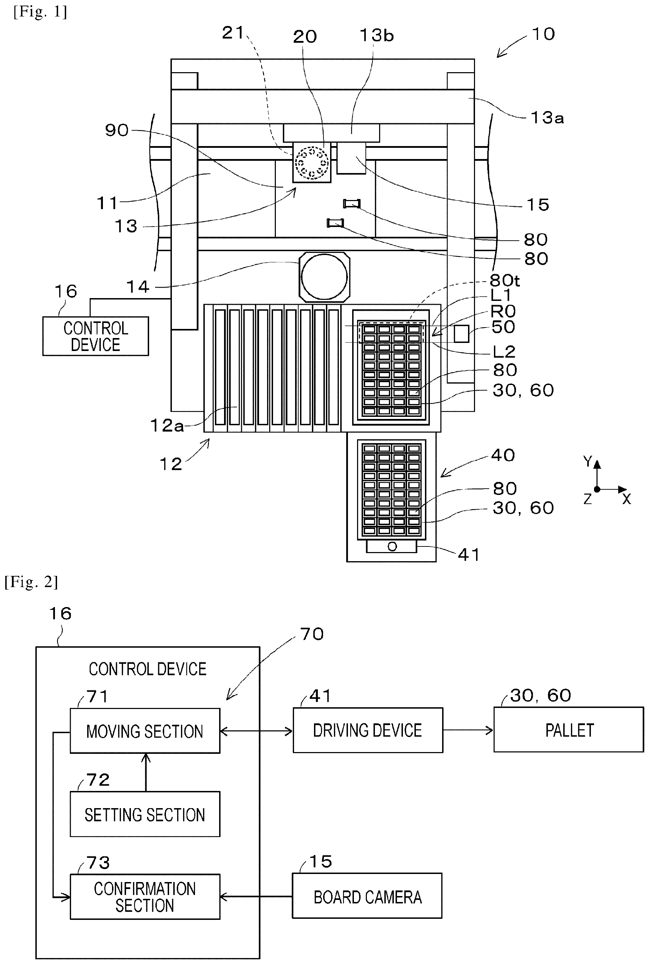

Component confirmation device 70 is provided in component mounter 10. Component mounter 10 mounts component 80 on board 90. As illustrated in Fig. 1, component mounter 10 includes board conveyance device 11, component supply device 12, component transfer device 13, part camera 14, board camera 15, and control device 16.

For example, board conveyance device 11 includes a belt conveyor, and conveys board 90 in a conveyance direction (an X-axis direction). Board 90 is a circuit board, and various circuits such as an electronic circuit, an electrical circuit, and a magnetic circuit are formed. Board conveyance device 11 conveys board 90 into component mounter 10, and positions that board 90 at a predetermined position inside component mounter 10 and clamps board 90. After component mounter 10 completes a process of mounting component 80, board conveyance device 11 unclamps board 90 and conveys board 90 out of component mounter 10.

Component supply device 12 supplies components 80 to be mounted on board 90. Component supply device 12 may include feeder 12a which is provided along the conveyance direction (the X-axis direction) of board 90. Feeder 12a indexes a carrier tape which accommodates multiple components 80 so that components 80 can be picked up at a supply position situated at a distal end side of feeder 12a. In addition, component supply device 12 can supply a relatively large electronic component (for example, a lead component) as compared with a chip component or the like, in such a state that the electronic component is disposed in pallet 30. Feeder 12a and pallet 30 are provided in component supply device 12 in a detachable (exchangeable) fashion.

Component transfer device 13 includes head driving device 13a and moving body 13b. Head driving device 13a is configured to move moving body 13b in the X-axis direction and a Y-axis direction (a direction orthogonal to the X-axis direction on a horizontal plane) by use of a linear motion mechanism. Mounting head 20 is attached to moving body 13b with a clamp member in a detachable (exchangeable) fashion. Using at least one holding member 21, mounting head 20 picks up and holds component 80 supplied by component supply device 12, and mounts component 80 on board 90 which has been positioned by board conveyance device 11. For example, a suction nozzle, a chuck, and the like may be used as holding member 21.

A well-known imaging device may be used for part camera 14 and board camera 15. Part camera 14 is fixed to a base of component mounter 10 in such a manner that an optical axis thereof is oriented upwards in a vertical direction (a Z-axis direction which is orthogonal to the X-axis direction and the Y-axis direction). Part camera 14 can image component 80 held by holding member 21 from below. Board camera 15 is provided on moving body 13b of component transfer device 13 in such a manner that an optical axis thereof is oriented downwards in the vertical direction (the Z-axis direction). Board camera 15 can image board 90 from above.

Part camera 14 and board camera 15 perform imaging based on a control signal transmitted from control device 16. Image data of images captured by part camera 14 and board camera 15 is transmitted to control device 16. Control device 16 includes an arithmetic device and a storage device, which are well known, as well as a control circuit which is configured therein. Information, image data, and the like which are output from various sensors provided in component mounter 10 are input to control device 16. Control device 16 transmits control signals to respective devices based on a control program, a predetermined mounting condition set in advance, and the like.

For example, control device 16 causes board camera 15 to image board 90 positioned by board conveyance device 11. Control device 16 performs image processing on the image captured by board camera 15 to recognize a positioning state of board 90. In addition, control device 16 causes holding member 21 to pick up and hold component 80 supplied by component supply device 12, and causes part camera 14 to image component 80 held by holding member 21. Control device 16 performs image processing on the image captured by part camera 14 to recognize a holding posture of component 80.

Control device 16 moves holding member 21 towards a position lying above a planned mounting position set in advance by the control program or the like. In addition, control device 16 corrects the planned mounting position based on the positioning state of board 90, the holding posture of component 80, and the like to set an actual mounting position where to mount component 80. The planned mounting position and the mounting position include rotation angles in addition to positions (X-axis coordinates and Y-axis coordinates).

Control device 16 corrects a target position (an X-axis coordinate and a Y-axis coordinate) and a rotation angle of holding member 21 in accordance with the mounting position. Control device 16 lowers holding member 21 at the corrected rotation angle in the corrected target position, to mount component 80 on board 90. Control device 16 executes a mounting processing of mounting multiple components 80 on board 90 by repeating a pick-and-place cycle.

### 1-2. Configuration Example of Component Confirmation Device 70

Component supply device 12 of the present embodiment images components 80 arranged in pallet 30 before components 80 are picked up to confirm components 80 based on a captured image of components 80. As illustrated in Fig. 1, component supply device 12 includes lighting device 50 illuminate components 80 when components 80 are imaged. For example, a well-known lighting device including an LED (Light Emitting Diode) may be used for lighting device 50. In lighting device 50 described above, lighting area R0 is limited, resulting in that all components 80 arranged in pallet 30 may not be illuminated at one time in some cases.

In the case in which component 80 is confirmed using lighting device 50 described above, a first one of pallet 30 and lighting device 50 needs to be moved relative to a second one of pallet 30 and lighting device 50. For example, if pallet 30 is moved every time one of components 80 accommodated in pallet 30 is picked up in order to pick up subsequent component 80, a waiting time is required until the movement of pallet 30 is completed. As a result, there is a possibility that the number of components 80 mounted per unit time is reduced, resulting in a possibility that the production efficiency is reduced.

Then, in the present embodiment, component mounter 10 includes component confirmation device 70. Component confirmation device 70 includes moving section 71. Component confirmation device 70 may include setting section 72. Component confirmation device 70 may also include confirmation section 73. As illustrated in Fig. 2, in the present embodiment, component confirmation device 70 includes moving section 71, setting section 72, and confirmation section 73.

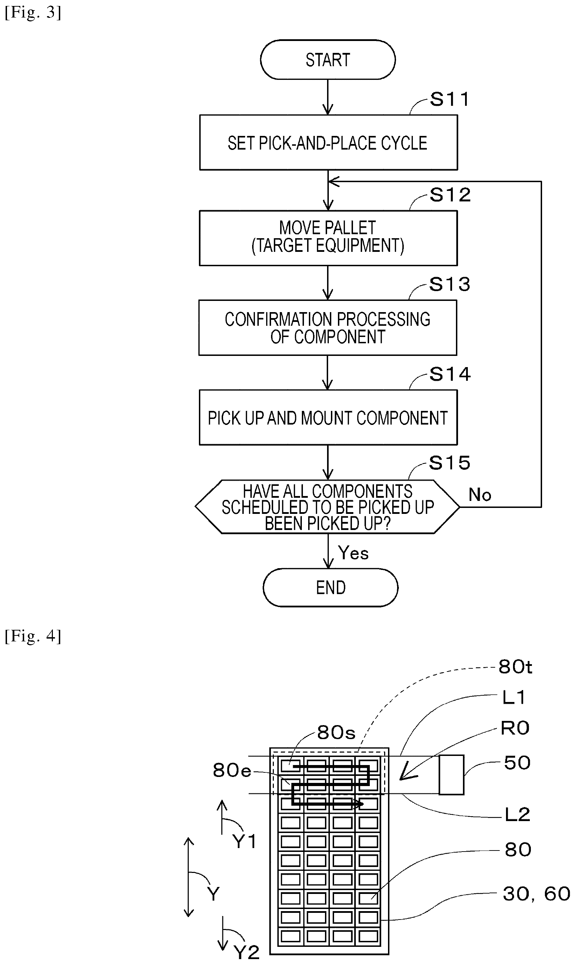

Component confirmation device 70 may be provided in various types of control devices or management devices, or on the cloud, or the like. As illustrated in Fig. 2, in the present embodiment, component confirmation device 70 is provided in control device 16 of component mounter 10. In addition, in the present embodiment, component confirmation device 70 executes control in accordance with a flowchart illustrated in Fig. 3. Moving section 71 executes processing described in step S12. Setting section 72 executes processing described in step S11. Confirmation section 73 executes processing described in step S13.

Here, if confirmation processing of confirming component 80 is executed in step S13, as has been described, control device 16 causes holding member 21 to pick up and hold component 80, to mount component 80 on board 90 (step S14). Subsequently, control device 16 determines whether all components 80 scheduled to be picked up have been picked up (step S15).

If all components 80 scheduled to be picked up have been picked up (Yes in step S15), the control is temporarily ended. If all components 80 scheduled to be picked up have not yet been picked up (No in Step S15), the control returns to the processing described in Step S12, and the processing described in steps S12 to S14 are repeated until all components 80 scheduled to be picked up are picked up.

### 1-2-1. Moving Section 71

As described above, using at least one holding member 21, mounting head 20 picks up and holds component 80 supplied by component supply device 12, and mounts component 80 on board 90 which has been positioned by board conveyance device 11. Mounting head 20 repeats the operations described above to mount multiple components 80 on board 90. To this end, a first one of pallet 30 and lighting device 50 may only have to be moved relative to a second one of pallet 30 and lighting device 50 in units of components 80 that are picked up by holding member 21 of mounting head 20.

A pick-and-place cycle is defined as a cycle from when mounting head 20 configured to pick up and mount component 80 on board 90 starts picking up target component 80t that is at least one component 80 which mounting head 20 picks up at one time until when mounting head 20 mounts target component 80t on board 90. At this time, moving section 71 moves target equipment 60 that is the first one of lighting device 50 that illuminates target component 80t when target component 80t is imaged and pallet 30, relative to the second one of lighting device 50 and pallet 30 as required every pick-and-place cycle (step S12).

In the present embodiment, target equipment 60 is pallet 30. As illustrated in Fig. 1, pallet 30 is moved in the Y-axis direction by, for example, driving device 41. Driving device 41 pulls out, from multiple pallets 30 accommodated in accommodation device 40, pallet 30 for use in production of board products and then moves pallet 30 in the Y-axis direction so as to equip that pallet 30 in component supply device 12. Driving device 41 can also recover used pallet 30 that has been used in production of board products from component supply device 12 back into accommodation device 40 by moving used pallet 30 in the Y-axis direction. In this way, in the present embodiment, moving section 71 can move pallet 30 relative to lighting device 50 using driving device 41.

Moving section 71 moves target equipment 60 (pallet 30 in the present embodiment) so that target component 80t which is to be picked up in one pick-and-place cycle is included in lighting area R0 that can be illuminated by lighting device 50. For example, 40 components 80 are arranged in cavities of 10 rows by 4 columns in pallet 30 illustrated in Fig. 1. As illustrated in Fig. 1, mounting head 20 includes eight holding members 21. For example, assume a case that target components 80t (eight components 80 of two rows) surrounded by a rectangle indicated by a dashed line in Fig. 1 are picked up in one pick-and-place cycle. Here, in Fig. 1, lighting area R0 of lighting device 50 is indicated as a region defined by straight line L1 and straight line L2 (for example, corresponding to two rows of pallet 30).

In this case, moving section 71 moves pallet 30 relative to lighting device 50 by a distance corresponding to two rows of pallet 30 every pick-and-place cycle. As a result, moving section 71 can move pallet 30 so that target components 80t (eight components 80 corresponding to two rows) which are to be picked up in one pick-and-place cycle are included in lighting area R0.

In an event that lighting area R0 corresponds to four rows of pallet 30, moving section 71 moves pallet 30 relative to lighting device 50 by a distance corresponding to the four rows at a cycle twice as long as the pick-and-place cycle. In this case, when pallet 30 is moved in a first pick-and-place cycle, pallet 30 is not moved in a second pick-and-place cycle subsequent to the first pick-and-place cycle. In this way, moving section 71 moves pallet 30 relative to lighting device 50 as required every pick-and-place cycle.

In addition, moving section 71 can move target equipment 60 (pallet 30 in the present embodiment) so that the number of target components 80t in lighting area R0 becomes maximum. For example, in a case in which a movement direction of pallet 30 in the Y-axis direction and a pickup direction of components 80 in the Y-axis direction are set opposite to each other, components 80 arranged in pallet 30 can be picked up sequentially while pallet 30 is being moved.

Specifically, as illustrated in Fig. 4, direction Y1 (a first direction of the Y-axis directions) in which pallet 30 is moved and direction Y2 (a second direction of the Y-axis directions) when components 80 are picked up sequentially as indicated by an arrowed thick line are opposite directions. In Fig. 4, among target components 80t which are to be picked up in one pick-and-place cycle, component 80 which is picked up first is denoted as first starting component 80s, and component 80 which is picked up last is denoted as last ending component 80e.

In this case, when moving section 71 moves pallet 30 so that the cavity accommodating first starting component 80s contacts straight line L1 which indicates the boundary of lighting area R0 on a side in direction Y1 (a side in the Y-axis direction in which pallet 30 is moved), the number of target components 80t in lighting area R0 becomes easily maximum.

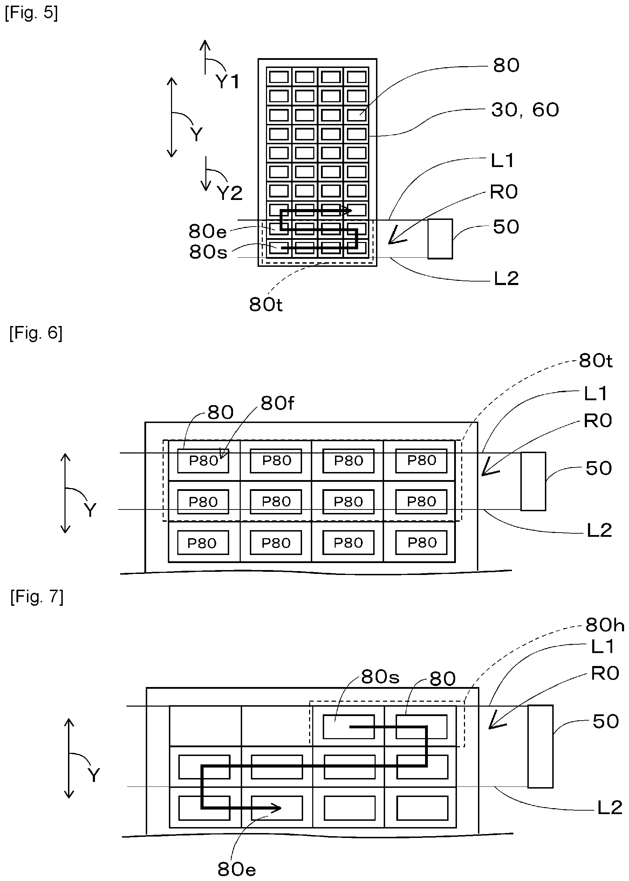

Similarly, as illustrated in Fig. 5, direction Y2 in which pallet 30 is moved and direction Y1 when components 80 are picked up sequentially as indicated by an arrowed thick line are opposite directions. In this case, when moving section 71 moves pallet 30 so that a cavity accommodating first starting component 80s contacts straight line L2 which indicates the boundary of lighting area R0 on a side in direction Y2 (a side in the Y-axis direction in which pallet 30 is moved), the number of target components 80t in lighting area R0 becomes easily maximum.

Component confirmation device 70 confirms target component 80t based on a captured image of target component 80t. For example, component confirmation device 70 can extract characteristic section 80f that is provided on an upper surface of target component 80t for confirmation of target component 80t from the image and confirm target component 80t based on extracted characteristic section 80f.

Characteristic section 80f may have various forms as long as target component 80t can be confirmed based on characteristic section 80f. Examples of characteristic section 80f include a character, a figure, a symbol, and the like which are affixed to the upper surface of target component 80t for confirmation of that target component 80t. Characteristic section 80f includes a three-dimensional shape such as a stamped mark formed in the upper surface of target component 80t for confirmation of that target component 80t.

In this case, moving section 71 may only have to move target equipment 60 (pallet 30 in the present embodiment) so that characteristic sections 80f, which are provided on the upper surfaces of target components 80t for confirmation of target components 80t, are included in lighting area R0. Specifically, as illustrated in Fig. 6, moving section 71 moves pallet 30 so that characteristic sections 80f (character P80 in Fig. 6) of target components 80t are included in a region defined by straight line L1 and straight line L2 which denote the boundaries of lighting area R0 (for example, an area corresponding to two rows of pallet 30). As a result, component confirmation device 70 can extract character sections 80f (characters P80) from the captured image and confirm target components 80t based on extracted characteristic sections 80f (characters P80).

### 1-2-2. Setting Section 72

Setting section 72 sets the pick-and-place cycle (step S11). Setting section 72 can set the pick-and-place cycle based on the control program, the predetermined mounting condition which is set in advance, and the like. For example, setting section 72 assigns components 80 and holding members 21 for picking up such components 80 in a mounting sequence order. Setting section 72 can set the pick-and-place cycle in accordance with the number, type, and the like of holding members 21 which are equipped on mounting head 20.

However, there may be a case in which a part of multiple target components 80t which are to be picked up in one pick-and-place cycle is left out of lighting area R0 that can be illuminated by lighting device 50. In this case, setting section 72 sets the pick-and-place cycle so that target components 80t which are included in lighting area R0 are picked up as scheduled in a first present pick-and-place cycle while target components 80t which are left out of lighting area R0 are picked up in a second pick-and-place cycle subsequent to the first pick-and-place cycle.

For example, it is assumed that mounting head 20 includes twelve holding members 21 so as to pick up twelve components 80 in one pick-and-place cycle. Also, for example, it is assumed that lighting area R0 of lighting device 50 corresponds to two rows of pallet 30 (eight components 80 can be illuminated at the most). In this case, four components 80 are left out of lighting area R0. Thus, setting section 72 sets a first pick-and-place cycle in which eight components 80 in lighting area R0 are assigned to target components 80t. In addition, setting section 72 sets a second pick-and-place cycle, subsequent to the first pick-and-place cycle, in which four components 80 left out of lighting area R0 are assigned to target components 80t.

Further, the number of target components 80t which are picked up in one pick-and-place cycle is not necessarily a multiple of a maximum number of components 80 (for example, four) which can be accommodated in one row of pallet 30. Therefore, for example, as illustrated in Fig. 7, there is a possibility that pallet 30 includes fraction section 80h that accommodates a fewer number of components 80 (two components 80 in Fig. 7) than the maximum number of components 80 that can be accommodated in one row (four in Fig. 7).

For example, it is assumed that mounting head 20 includes eight holding members 21, and that eight components 80 can be picked up in one pick-and-place cycle. Also, for example, it is assumed that lighting area R0 of lighting device 50 corresponds to two rows of pallet 30 (eight components 80 can be illuminated at the most). In this case, when eight components 80 including components 80 in fraction section 80h are attempted to be picked up in one pick-and-place cycle, two components 80 are left out of lighting area R0.

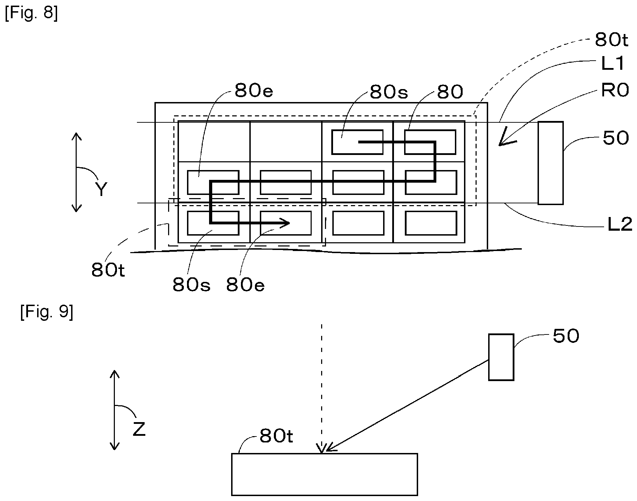

Therefore, as illustrated in Fig. 8, setting section 72 sets a first pick-and-place cycle in which six components 80 in lighting area R0 are assigned to target components 80t. In addition, setting section 72 sets a second pick-and-place cycle, subsequent to the first pick-and-place cycle, in which two components 80 left out of lighting area R0 are assigned to target components 80t. It is noted that, in a case in which two components 80 in fraction section 80h are not picked up in the above example, setting section 72 may also set one pick-and-place cycle in which eight components 80 are assigned to target components 80t.

### 1-2-3. Confirmation Section 73

After moving section 71 has moved target equipment 60 (pallet 30 in the present embodiment), component confirmation section 70 images target components 80t while illuminating target components 80t with lighting device 50. Imaging of target components 80t may be executed using a well-known imaging device. For example, component confirmation device 70 can image target components 80t using board camera 15.

Confirmation section 73 performs confirmation processing of performing image processing on image data generated by imaging target components 80t to confirm at least whether target components 80t which are to be picked up by mounting head 20 are correct ones among whether target components 80t to be picked up by mounting head 20 are correct ones and an angle in picking up target components 80t (step S13). Confirmation section 73 may only have to perform the confirmation processing, and an image processing method is not particularly limited. Confirmation section 73 can extract characteristic section 80f described above by, for example, binarization processing or the like, and perform confirmation processing based on extracted characteristic section 80f.

For example, assume a case in which confirmation section 73 recognizes a character affixed to the upper surface of target component 80t for confirmation of target component 80t and then performs the confirmation processing. In this case, when lighting device 50 emits epi-light in a normal direction of the upper surface of target component 80t as indicated by an arrowed dashed line in Fig. 9, there may be a case in which it is difficult to recognize characters due to total reflection or the like.

Thus, in the present embodiment, as illustrated in Figs. 1 and 9, lighting device 50 illuminates target component 80t arranged in pallet 30 sideways. An irradiation angle of illumination at which the upper surface of target component 80t is irradiated is obtained in advance through, for example, simulation, verification using an actual device, or the like and is set so as to recognize characters.

Confirmation section 73 performs image processing on the image data, recognizes a character affixed to the upper surface of target component 80t for confirmation of target component 80t, and performs the confirmation processing based on the recognized character. In the example illustrated in Fig. 6, confirmation section 73 can recognize characters P80 to confirm whether target components 80t to be picked up by mounting head 20 are correct ones. For example, character P80 denotes a component type of target components 80t.

Confirmation section 73 determines whether the component type of target components 80t which are to be picked up by mounting head 20 matches the component type denoted by character P80 recognized through the image processing of the image data. If the component types match, confirmation section 73 determines that target components 80t which are to be picked up are correct ones, while if the component types do not match, confirmation section 73 determines that target components 80t which are to be picked up are not correct ones.

In addition, confirmation section 73 can also confirm an angle in picking up target components 80t based on the visual angle at which character P80 can be recognized. Here, confirmation section 73 can also confirm the angle in picking up target components 80t by recognizing, for example, a figure (for example, a triangle) which is provided at a corner portion of target component 80t.

### 1-2-4. Another Example

In the embodiment described heretofore, target device 60 is pallet 30. Target device 60 may be lighting device 50. In this case, lighting device 50 is provided so as to be movable along the Y-axis direction by, for example, a well-known linear motion mechanism or the like. In addition, moving section 71 moves lighting device 50 relative to pallet 30 as required every pick-and-place cycle.

### 1-3. Component Confirmation Method

What has been described heretofore on component confirmation device 70 is applicable to a component confirmation method. Specifically, the component confirmation method includes a moving step. The moving step corresponds to the control executed by moving section 71. The component confirmation method may also include a setting step. The setting step corresponds to the control executed by setting section 72. The component confirmation method may also include a confirmation step. The confirmation step corresponds to the control executed by confirmation section 73.

### 2. Example of Advantageous Effects of Embodiment

Component confirmation device 70 includes moving section 71. With this configuration, component confirmation device 70 can move target equipment 60, which is a first one of lighting device 50 and pallet 30, relative to a second one of lighting device 50 and pallet 30 as required every pick-and-place cycle, in imaging of target components 80t. As a result, component confirmation device 70 can prevent a reduction in production efficiency compared with a case in which pallet 30 or lighting device 50 is moved for pickup of a subsequent component 80 every time one component 80 is picked up. What has been described heretofore on component confirmation device 70 is also applicable to the component confirmation method.

### Reference Signs List

20: mounting head, 30: pallet, 50: lighting device, 60: target equipment, 70: component confirmation device, 71: moving section, 72: setting section, 73: confirmation section, 80: component, 80t: target component, 80f: characteristic section, 90: board, R0: lighting area

## Claims

1. A component confirmation device for imaging components arranged in a pallet before the components are picked up to confirm the components based on a captured image of the components, the component confirmation device comprising:
a moving section, wherein
a pick-and-place cycle is defined as a cycle from when a mounting head configured to pick up and mount a component on a board starts picking up a target component that is at least one of the components that the mounting head picks up at one time until when the mounting head mounts the target component on the board, and
the moving section is configured to move target equipment that is a first one of a lighting device configured to illuminate the target component and the pallet, relative to a second one of the lighting device and the pallet as required every pick-and-place cycles, in imaging of the target component.

2. The component confirmation device according to claim 1, wherein the moving section moves the target equipment so that the target component which is to be picked up in one of the pick-and-place cycles is included in a lighting area where the target component can be illuminated by the lighting device.

3. The component confirmation device according to claim 2, wherein the moving section moves the target equipment so that the number of target components which are included in the lighting area becomes maximum.

4. The component confirmation device according to claim 2 or 3, wherein the moving section moves the target equipment so that a characteristic section provided on an upper surface of the target component for confirmation of the target component is included in the lighting area.

5. The component confirmation device according to any one of claims 1 to 4, comprising:
a setting section configured to, when a part of multiple the target components which are to be picked up in one of the pick-and-place cycles is left out of a lighting area that can be illuminated by the lighting device, set the pick-and-place cycle so that the target component included in the lighting area is picked up in a first one of the pick-and-place cycles and the target component left out of the lighting area is picked up in a second one of the pick-and-place cycles subsequent to the first one of the pick-and-place cycles.

6. The component confirmation device according to any one of claims 1 to 5, comprising:
a confirmation section configured to perform confirmation processing of performing image processing on image data obtained by imaging the target component to confirm at least whether the target component is correct one among whether the target component to be picked up by the mounting head is correct one and an angle in picking up the target component.

7. The component confirmation device according to claim 6, wherein
the lighting device illuminates the target component arranged in the pallet sideways, and
the confirmation section performs image processing on the image data to recognize a character affixed to an upper surface of the target component for confirmation of the target component and performs the confirmation processing based on the recognized character.

8. A component confirmation method for imaging components arranged in a pallet before the components are picked up to confirm the components based on a captured image of the components, the method comprising:
a moving step, wherein
a pick-and-place cycle is defined as a cycle from when a mounting head configured to pick up and mount a component on a board starts picking up a target component that is at least one of the components that the mounting head picks up at one time until when the mounting head mounts the target component on the board, and
the moving section comprises moving target equipment that is a first one of a lighting device configured to illuminate the target component and the pallet, relative to a second one of the lighting device and the pallet as required every pick-and-place cycles, in imaging of the target component.
